# EUROPEAN PATENT SPECIFICATION

(11) **EP 1 048 085 B1**
(45) Date of publication and mention of the grant of the patent: **14.11.2007**
(21) Application number: 99948955.2
(22) Date of filing: 24.09.1999
(51) Int. Cl.: H01L 33/00

(54) **LED MODULE AND LUMINAIRE**
LED-MODUL UND LEUCHTE
MODULE A DIODE LUMINESCENTE ET LUMINAIRE

(30) Priority: 21.10.1998 EP 98203545
(43) Date of publication of application: 02.11.2000
(73) Proprietor: Koninklijke Philips Electronics N.V., 5621 BA Eindhoven (NL); Lumileds Lighting B.V., 5680 AK Best (NL)
(72) Inventor: KEUPER, Matthijs, H., NL-5656 AA Eindhoven (NL); PASHLEY, Michael, D., NL-5656 AA Eindhoven (NL)
(74) Representative: Dusseldorp, Jan Charles
(86) International application number: PCT/EP1999/007456
(87) International publication number: WO 2000/024062

(56) References cited:
- EP-A- 0 798 788
- WO-A-98/33007
- DE-A- 19 507 234
- PATENT ABSTRACTS OF JAPAN vol. 011, no. 051 (E-480), 17 February 1987 (1987-02-17) & JP 61 214485 A (STANLEY ELECTRIC CO LTD), 24 September 1986 (1986-09-24)

## Description

The invention relates to a LED module comprising a LED (light-emitting diode) and a rotationally symmetrical, bowl-shaped collimator lens which is provided with a recess in which the LED is situated, and which collimator lens is also provided with a flat surface from which light generated by the LED emerges, the normal to the surface extending substantially parallel to the axis of symmetry of the lens. The invention also relates to a luminaire provided with a number of said LED modules.

DE 195 07 234 discloses a LED module in accordance with the preamble of claim 1, and relates to a signal light for a vehicle comprising a plurality of LEDs and inner and outer optical structures. The inner optical structure is arranged to focus light while the other outer structure defines radiation of the focused light outwards. The inner and the outer optical structures of the LEDs are integrated in a single, common, optical component. Preferably, to each LED there is allocated a raster section of the optical component with both optical structures aligned each at the LED optical axis. Typically the light spot of each diode is located in the focal points on the allocated raster sections of the respective structures.

International patent application WO 98/33007 discloses a luminaire comprising a housing with a light emission window, at least one lighting module being accommodated in the housing for illuminating an object. The lighting module comprises a light source, optical means, a set of lighting units, which each comprises at least a LED chip and an optical system coupled thereto, the LED chips and the optical system forming the light sources and the optical means, respectively. The light generated by the light source is utilized in a comparatively efficient manner in the luminaire according to the invention.

In European patent application, EP 0 798 788, there is disclosed a display sign comprising a plurality of electro-optical devices, each electro-optical device having an optical element mounted thereon, the optical element having surfaces at which any stray light emitted from the electro-optical device is reflected. Further, a plurality of angled surfaces (faces) from which a light beam is emitted, wherein each face is angled to direct the light emitted there from in a different direction to shape the light beam and increase the beam intensity in a predetermined direction.

A LED for a light source is known from Japanese patent application 60-055590. The Japanese patent application discloses a LED and a total reflection lens, forming an approximately parabolic curved surface

A LED module of the type mentioned in the opening paragraph is known per se. For example in the English-language abstract of Japanese patent application JP 61-147.585, a description is given of such a LED module. This LED module comprises a LED which is secured onto a substrate and which is positioned in the recess of a bowl-shaped collimator lens. This lens is rotationally symmetrical in shape and has an associated axis of symmetry. The position of the LED and the shape of the lens are attuned to each other in such a manner that a large part of the light generated by the LED is converted via refraction and reflection into a parallel light beam, which leaves the lens via a flat surface. The lens and the substrate are secured in a metal housing.

The known LED module has an important drawback. The emerging light leaves the lens in a direction, which is substantially parallel to the axis of symmetry of the lens. Under certain conditions it is desirable for the parallel beam to leave the lens at a certain angle, viewed relative to the axis of symmetry. This angle must be at least 20°.

It is an object of the invention to obviate said drawback. The invention more particularly aims at providing a LED module of the above-mentioned type, in which the light emerges at a specific angle relative to the axis of symmetry of the lens. The proposed LED module should additionally be compact. Besides, said LED module must have a simple structure and its manufacture must be inexpensive.

These and other objects of the invention are achieved by a LED module comprising a LED (light-emitting diode) and a rotationally symmetrical, bowl-shaped collimator lens which is provided with a recess in which the LED is situated and which collimator lens is also provided with a flat surface from which light generated by the LED emerges, the normal to the surface extending substantially parallel to the axis of symmetry of the lens, and which surface is provided with a sawtooth-like structure for deflecting the emerging light.

The invention is based on the recognition that such a sawtooth-like structure offers a good solution to the deflection of the parallel beam leaving the lens. Since the maximum dimensions of the teeth are very small (below 1 mm), such a sawtooth-like structure can be provided in a relatively thin layer (thickness below 1 mm). By virtue thereof, also the maximum dimensions of the LED module remain limited. In comparison to alternative solutions in which a separate prism is arranged in front of the emergent face of the lens, or the lens is bevelled, the present solution offers compact, inexpensive LED modules which can be readily manufactured. This applies in particular if deflection angles of 20° and more must be obtained.

The LED module in accordance with the invention is characterized in that the sawtooth-like structure is provided in a separate foil, which is secured to the surface of the collimator lens. Such foils are commercially available, for example from 3M. The thickness of these foils is below 1 mm. The foils can be readily secured to the flat surface of the lens, preferably by means of an adhesive.

A LED module not in accordance with the invention is characterized in that the sawtooth-like structure is pressed into the surface of the collimator lens. In practice, a template whose pressing surface is provided with the negative of this structure will be used to press-in such a sawtooth-like structure. In principle, it is possible to use collimator lenses of mouldable glass for this purpose. In practice, however, it is more convenient to provide such a structure in collimator lenses of a thermoplastic synthetic resin while they are subjected to heat. These lenses can be obtained by means of injection molding. Very good results are achieved using lenses of polycarbonate.

Another LED module not in accordance with the invention is characterized in that the sawtooth-like structure in the surface of the collimator lens is obtained by means of a replica technique. In this technique, a solution of thermally curable or UV-curable material is provided on the flat surface of the known lens. Subsequently, a template whose active surface is provided with the negative of the intended sawtooth-like structure is pressed into this liquid, whereafter the liquid is cured by exposure to heat or to UV radiation. Subsequently, the template is removed. This method also enables the entire lens to be manufactured in a single step. It has been found that particularly (methyl) methacrylate compounds are very suitable for manufacturing the intended collimator lenses.

The invention also relates to a luminaire comprising a box-like housing which accommodates a number of LED modules, each module including a LED and a collimator lens, said lens being provided with a flat surface from which light generated by the LED emerges. This luminaire is characterized in that the surface is provided with a sawtooth-like structure for deflecting the emerging light. Such luminaires are compact and can be readily and inexpensively manufactured.

These and other aspects of the invention are apparent from and will be elucidated with reference to the embodiments described hereinafter.

In the drawings:
Fig. 1 is a diagrammatic, sectional view of an embodiment of a known LED module,
Fig. 2 is a diagrammatic, sectional view of a first embodiment of the LED module in accordance with the invention,
Fig. 3 is a diagrammatic, sectional view of a LED module not in accordance with the invention,
Fig. 4 is a diagrammatic, sectional view of a luminaire in accordance with the invention.

It is noted that in the Figures like reference numerals refer to like parts. It is also noted that the drawings are not to scale.

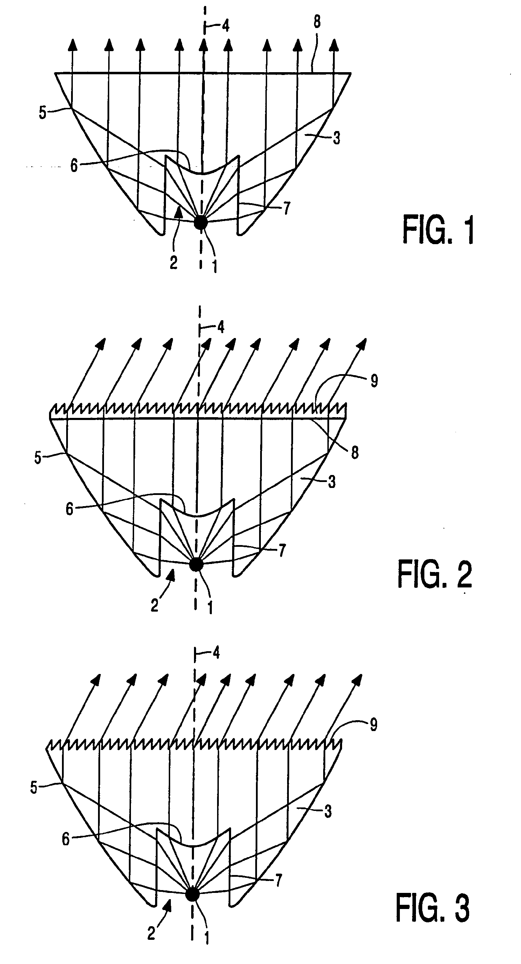

Fig. 1 is a diagrammatic, sectional view of the essential parts of a LED module in accordance with the state of the art. This module comprises a LED (1) (indicated by means of a dot) which is positioned in a recess (2) of a rotationally symmetrical, bowl-shaped collimator lens (3). The axis of rotation of lens (3) is indicated by means of an interrupted line (4). The shape of the curved outside surfaces (5) and (6) of the lens approximates to a certain degree to the shape of the outside surface of the body of revolution of a parabole. The LED is positioned in the focus of this approximate parabole. The surfaces (7) and (8) are predominantly cylindrical and flat, respectively. For clarity, the parts of the LED module keeping the lens and the LED fixed relative to each other are not shown.

Fig. 1 also diagrammatically shows (by means of arrows) the optical path of a substantial part of the light generated by the LED (1). This is converted by the lens (3) into a parallel beam, either via deflection onto the lens surface (6) or via deflection onto the lens surface (7) and total reflection at the lens surface (5). The emerging parallel light beam extends substantially parallel to the axis of symmetry (4) of the lens.

Fig. 2 is a schematic, sectional view of a LED module in accordance with the invention. This LED module comprises the essential parts of the LED module shown in Fig. 1. The collimator lens (3) of the module additionally includes a sawtooth-like structure (9) which is glued in the form of a separate foil (a so-called "image directing film", make 3M) onto surface (8) of the collimator lens by means of Dymax 625 (make Dymax). It has been found that by means of this LED module a 30. deflection of the light beam relative to the normal to the surface (8) can be achieved. In the present case, the lens was made of polymethyl methacrylate (PMMA).

Fig. 3 shows a LED module not in accordance with the invention. This module too comprises the essential parts of the module shown in Fig. 1. The collimator lens of the module additionally comprises a sawtooth-like structure which is provided by means of a replica technique. In the present case, the lens is made from polymethyl methacrylate. This lens enables a 40°-deflection of the light beam relative to the axis of symmetry (4) to be achieved.

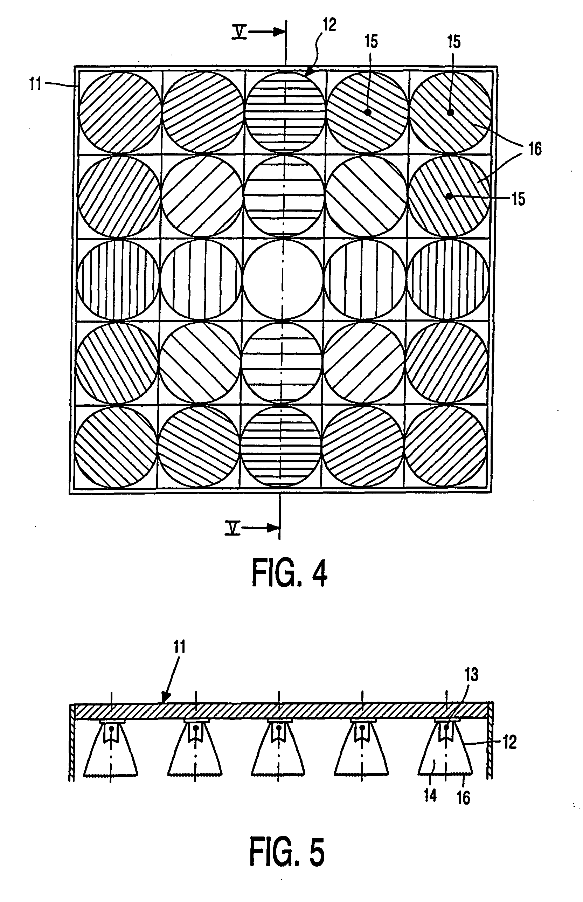

Fig. 4 schematically shows a luminaire in accordance with the invention. Fig. 4-a is a plan view of said luminaire. Fig. 4-b is a cross-sectional view taken on the lines IV-IV. The luminaire comprises a box-like housing (11) accommodating 25 LED modules (12). These modules each include a LED (13) and a collimator lens (14). Each of these lenses has an axis of symmetry (15) which extend in mutually parallel directions.

The emergent face of each lens is provided with a sawtooth-like structure (16) for deflecting the emerging light generated by the relevant LED (13). In the present case, this structure (16) consists of a glued foil (see above) in which a sawtooth-like structure is provided.

The individual foils of each of the collimator lenses of the luminaire may be oriented in such a way that the deflected beams are directed parallel to each other. It is alternatively possible, however, to orient the individual foils in such a manner that another, desirable illumination pattern is formed. It is also possible to use sawtooth-like structures with different deflection angle for the different LED modules, as schematically shown in Fig. 4. It is also possible to use different types of LEDs, so that a desired color and/or intensity pattern can be obtained.

## Claims

1. A LED module comprising a LED (1) and a rotationally symmetrical, bowl-shaped collimator lens (3) which is provided with a recess (2) in which the LED (1) is situated, and which collimator lens (3) is also provided with a flat surface (8) from which light generated by the LED (1) emerges, the normal to the surface (8) extending substantially parallel to the axis of symmetry (4) of the lens (3), said surface (8) being provided with a sawtooth-like structure (9) for deflecting the emerging light, **characterized in that** said sawtooth-like structure (9) is provided in a separate foil, which is secured to the surface (8) of the collimator lens (3).

2. A luminaire comprising a box-like housing which accommodates a number of LED modules in accordance with claim 1.

## Patentansprüche

1. LED-Modul mit einer LED (1) und einer rotationssymmetrischen, schalenförmigen Kollimatorlinse (3), die mit einer Vertiefung (2) versehen ist, in welcher sich die LED (1) befindet, und die ebenfalls mit einer ebenen Oberfläche (8) versehen ist, aus der von der LED (1) erzeugtes Licht austritt, wobei sich die Senkrechte zu der Oberfläche (8) im Wesentlichen parallel zu der Symmetrieachse (4) der Linse (3) erstreckt, wobei die Oberfläche (8) mit einer sägezahnartigen Struktur (9) zur Ablenkung des austretenden Lichts versehen ist, **dadurch gekennzeichnet, dass** die sägezahnartige Struktur (9) in einer separaten Folie vorgesehen ist, welche an der Oberfläche (8) der Kollimatorlinse (3) befestigt ist.

2. Leuchte mit einem kastenartigen Gehäuse, welches mehrere LED-Module nach Anspruch 1 aufnimmt.

## Revendications

1. Module à diode électroluminescente comprenant une diode électroluminescente et une lentille collimatrice à symétrie de rotation et en forme de cuvette (3) qui est pourvue d'un évidement (2) dans lequel se situe la diode électroluminescente (1) et laquelle lentille collimatrice (3) est également pourvue d'une surface plate (8) de laquelle apparaît la lumière qui est générée par la diode électroluminescente (1), la normale par rapport à la surface (8) s'étendant sensiblement en parallèle à l'axe de symétrie (4) de la lentille (3), ladite surface (8) étant pourvue d'une structure en dents de scie (9) pour faire dévier la lumière naissante, **caractérisé en ce que** ladite structure en dents de scie (9) est prévue dans une feuille séparée qui est fixée à la surface (8) de la lentille collimatrice (3).

2. Luminaire comprenant un boîtier en forme de boîte qui comprend un certain nombre de modules à diode électroluminescente selon la revendication 1.
